Europäisches Patentamt

European Patent Office

Office européen des brevets

(19)

(11) Publication number: **0 057 232 B1**

# (12) EUROPEAN PATENT SPECIFICATION

(45) Date of publication of patent specification: **25.03.87**

(51) Int. Cl.⁴: **C 25 D 3/38**

(21) Application number: **81902342.5**

(22) Date of filing: **10.08.81**

(86) International application number:
**PCT/US81/01074**

(87) International publication number:
**WO 82/00666 04.03.82 Gazette 82/07**

(54) **METHOD FOR CONTINUOUS METAL DEPOSITION FROM A NON-AUTOCATALYTIC ELECTROLESS PLATING BATH USING ELECTRIC POTENTIAL.**

(30) Priority: **12.08.80 US 177486**

(43) Date of publication of application:
**11.08.82 Bulletin 82/32**

(45) Publication of the grant of the patent:
**25.03.87 Bulletin 87/13**

(84) Designated Contracting States:
**CH DE FR GB LI NL SE**

(56) References cited:
**GB-A-1 222 969**
**GB-A-1 288 620**
**US-A-2 644 787**
**US-A-3 264 199**
**US-A-3 303 111**
**US-A-3 485 725**
**US-A-3 597 266**
**US-A-4 086 149**
**US-A-4 099 974**
**US-A-4 209 331**

(73) Proprietor: **MACDERMID, INCORPORATED**
**50 Brookside Road**
**Waterbury, CT 06708 (US)**

(72) Inventor: **KUKANSKIS, Peter E.**
**245 Quassapaug Road**
**Waterbury, CT 06798 (US)**

(74) Representative: **Warren, Anthony Robert et al**
**BARON & WARREN 18 South End Kensington**
**London W8 5BU (GB)**

# 0 057 232

**Description**

This invention relates to the deposition of copper on the surface of a workpiece from a non-autocatalytic electroless plating bath. The term "non-autocatalytic" is used herein to denote plating baths which do not maintain a catalytic surface capable of catalysing the reduction of metal ions once the initial plating surface is covered with a plated metal layer. Thus they are inherently self-limiting as to the thickness of metal which can be deposited. In particular, this invention relates to the electroless deposition of copper from non-autocatalytic electroless copper plating baths utilizing a reducing agent to reduce copper ions dissolved in the solution to metallic copper to provide copper deposits or films on a suitably prepared substrate contacted by the bath solution. An example of such a copper plating bath is disclosed in US—A—4 207 331.

In US—A—4 207 331 hypophosphite is disclosed as a reducing agent which is useful as a reducer for copper ions in electroless plating baths. The hypophosphite reduced copper system is inherently non-autocatalytic to copper, in contrast to presently known formaldehyde reduced systems which are inherently autocatalytic to copper, and thus results in copper depositions of limited thickness.

In US—A—4 265 943 there is disclosed an invention which overcomes the self-limiting nature of a hypophosphite reduced and similar non-autocatalytic copper system so as to provide continuous plating, that is, plating to a desired thickness which increases with time at a substantially constant rate of metallic copper when utilizing a non-formaldehyde type reducing agent, electroless copper plating bath. Such is achieved, in the invention disclosed in US—A—4265943 by including, in the system, a source of non-copper ions, preferably nickel or cobalt ions. The plating obtained in that invention is said to be essentially that of copper with only small quantities of the non-copper metal being codeposited with copper. The codeposited metal is said to function as an autocatalysis promoter so that metallic copper deposits or films of a desired thickness, greater than the limiting thickness obtainable before, are obtained as a continuous plating step, that is, as a plating operation wherein the plating thickness increases with time at a substantially constant rate.

The discussion of the prior art in US—A—4207331 and US—A—4265943 referred to above, both of which are incorporated by reference herein, reveals that it was surprising and unexpected that a non-formaldehyde type reducing agent such as hypophosphite, would successfully reduce copper ions to metallic copper for electroless deposition while yielding advantages not previously available in typical formaldehyde reduced systems and that the self-limiting nature of the hypophosphite reduced system could be overcome by the addition of nickel or cobalt ions so that the system was no longer non-autocatalytic.

Plating processes wherein electrolytic current is used in conjunction with electroless plating are known. For example, US—A—2,644,787 discloses a combination of electroplating and chemical plating, in a bath containing nickel, cobalt and hypophosphite ions, onto a conductive substrate to produce a magnetic coating. The patent discloses current densities of 10 to 200 amps per sq. ft. approx. $1.08 \cdot 10^{-2}$ to 0.22 amps $\cdot$ cm$^{-2}$ in a bath solution having a pH from 2 to 6, and states that the process yields deposits in excess of those expected from the current flow.

US—A—3,264,199 describes a process for depositing nickel coatings on a metallic object by an autocatalytic chemical reduction reaction in a bath containing nickel salt and hypophosphate. The uniformity of the rate of the electroless deposition process is said to be materially aided by the addition of superimposed direct current pulses at periodic intervals. The patent further states that the current provides an electrochemical action acting as an aid to the chemical reduction process and, in effect, increase the rate of deposition of the electroless process but that the addition of a small current density does not increase the rate due to an electroplating action.

In US—A—3,303,111 there is described a process for depositing nickel on a metal surface from a nickel-hypophosphite bath using AC or DC current to speed up the deposition of nickel. The patent states that the process is not one of electroplating, but, rather, is one in which the applied current apparently supplements the galvanic potential of the hypophosphite and excites it to do work which it could not do without such supplemental energy.

US—A—3,485,725 discloses controlling the rate of deposition of metal on to a non-metallic substrate from an electroless plating bath by impressing an electric potential on the surface of the substrate. An example in the patent shows the use of current in an autocatalytic nickel or cobalt-hypophosphate bath to increase or decrease plating rate. It is said that this results in a unique phenomenon in that more plate is achieved than expected from a yield based on the sum of the electroless and electrolytic action.

GB—A—1 222 969 discloses a process of depositing a metal layer e.g. copper onto a substrate by an electroless plating process in an autocatalytic electroless plating bath followed by an electroplating process without removing the substrate from the plating solution.

The various patents discussed above disclose the use of an electric current in electroless copper, nickel or cobalt baths, all of which are autocatalytic. Such baths maintain a catalysed surface for plating even when the original catalysed surface is covered with a plated metal layer so that plating continuous while sufficient metal ions remain in solution. Thus, in the above patents, the bath compositions disclosed invariably employ formaldehyde type reducing agents for copper formulations and hypophosphite type

2

reducing agents for nickel formulations, similar to the disclosures made in the prior art disclosed in US—A—4 207 331 and US—A—4265943.

The electroless plating and electrolytic plating disclosed in the above patents continue concurrently with the electric current being employed primarily to boost the plating rate. The patents are silent with respect to electroless plating baths which are non-autocatalytic and inherently self-limiting as to plating thickness, such as the hypophosphite reduced bath disclosed in US—A—4 207 331. In contrast to formaldehyde-reduced copper solutions and hypophosphite-reduced nickel solutions, hypophosphite-reduced copper solutions are not autocatalytic so that catalysis ceases when the surface of the substrate is covered with a deposit at about 10 micro inches (c.o 25µm) thick.

It is generally necessary to build up plate thicknesses greater than 0.25 µm for commercial uses. Even where conventional electroplating is to follow electroless plating to build a plate thickness, such procedure is not commercially acceptable in many instances where the initial deposit obtained by electroless plating is too thin.

For example, when workpieces are removed from a non-autocatalytic electroless plating bath that has been self-limiting as to thickness so that a thin plating only has been obtained, there is the possibility that the connection between the parts or workpieces and the plating rack or fixture will be broken, thus destroying the conductor bridge necessary to get electric current to the part. This increases the incidence of burnoff in subsequent electroplating.

Another possible disadvantage is the possibility of bipolar deplating due to the thin deposit. Bipolar deplating occurs where a low current density area of a workpiece becomes anodic, due to the limited current carrying capability of the thin deposit, to an adjacent area of the piece which is cathodically plating. This can cause dissolution of the thin anodic electroless deposit which, if too thin, can be completely stripped away.

In addition, workpieces that have been electrolessly plated with a thin deposit and stored prior to electroplating may require reactivation prior to plating by techniques which might remove copper which cannot be spared by thin deposits. Also, processes which require intermediate operation, such as imaging techniques in the manufacture printed circuits, often require greater copper thickness than can be provided in non-autocatalytic baths which are inherently self-limiting as to thickness.

While the method and composition disclosed in US—A—4265943 overcome the disadvantages discussed above, the plating obtained contains a minor amount of the noncopper ion, such as nickel or cobalt, added to the plating solution. In addition, the system provides for continuous plating, wherein the plating thickness increases with time at a substantially constant rate as a consequence of the deposit becoming autocatalytic, through a chemical change, that is, a change in the composition of the plating bath such as by the addition of nickel and cobalt. Thus, there exists a need for alternative means to overcome the disadvantages of non-autocatalytic electroless plating baths discussed above.

The present invention consists in a method of depositing a copper plating on the surface of a workpiece which comprises the steps of preparing the workpiece surface to render it more receptive to plating, immersing the workpiece in an electroless plating solution comprising, in addition to water, a soluble source of copper ions, a complexing agent to maintain the copper ions in solution and a soluble reducing agent effective to reduce the copper ions to metallic copper as a deposit on the surface of the workpiece when in contact with the plating solution, applying a negative potential to the partially plated workpiece and completing an electric circuit by placing an anode in effective electrical contact with the solution, to continue the plating by electrolysis in the plating solution characterised in that the reducing agent is a hypophosphite.

It is possible in this way to overcome the drawbacks associated with electroless plating baths which inherently result in self-limiting thickness of deposit, while retaining the principal advantages of such baths.

The foregoing is achieved, according to this invention, by a method which allows build-up of any desired deposit thickness in previously self-limiting electroless plating baths by applying an electric potential on the substrate to be plated in such baths. The thickness increases at a rate of deposition dependent on the amount of current applied and which thus can be controlled, by varying the current density applied, to obtain a substantially constant rate which, if desired, may be essentially the same as the initial rate of deposition.

The electroless copper plating baths employed in the method of the invention are formulated to be non-autocatalytic as a consequence of which the usual problems associated with electroless baths may be avoided. One advantage of such non-autocatalytic baths is that they are more stable and have a greater tolerance to changes inevitably encountered in practical commercial operation. For example, non-autocatalytic plating baths allow wider operating parameters in terms of component concentration, temperature, plating time and similar bath variables such that the parameters are commercially acceptable.

Another advantage of the non-autocatalytic baths which can be successfully commercially employed through the method of this invention is that the copper to be deposited plates out onto catalyzed surfaces only. In typical autocatalytic baths, the metal to be deposited plates out on every surface, including tanks, filters and other associated equipment. As a result, considerable time and money must be spent to strip metal off extraneous surfaces. Non-autocatalytic baths do not require this maintenance. In addition, the use

# 0 057 232

of a non-formaldehyde reducer in such baths eliminates the harmful environmental effects associated with the toxic and irritating fumes of formaldehyde.

The present invention provides non-autocatalytic baths with the ability to plate on nonconductors to a desired thickness with the application of current to the nonconductor to make possible the use of such non-autocatalytic baths where they would otherwise be commercially unsatisfactory. It is both surprising and unexpected that the plating obtained using the method of this invention in a hypophosphite reduced copper bath results in a very uniform thickness over the entire workpiece being plated. That is, in normal electroplating baths the high current density areas plate more thickness than do the low current density areas, a differential which can be substantial. By contrast, the electrolytic action of the method of this invention, through the application of current to hypophosphite reduced electroless copper baths, provides a means for achieving a greater deposit penetration into blind holes, deep recesses and tubular parts resulting in a more uniform deposit.

In the case of plating nonconductors with complex shapes, problems of bipolar plating in recesses or other low current density areas which can occur in subsequent electroplating operations, as discussed above, may be avoided using the method of this invention.

Representative of the electroless baths having the feature of inherent self-limiting thickness of deposit by chemical reduction which can be advantageously utilized in this invention are such as those disclosed in US—A—4 207 331. The plating solutions include the usual major categories of components of electroless copper baths such as water, a source of cupric ions, a complexing agent, the reducing agent, which in this case is a soluble source of hypophosphite and, where required, a pH adjuster. The concentrations of the various constituents and other operating parameters of the electroless bath are such that they provide a conductive metal film over a suitably catalyzed non-conductive substrate.

The workpiece, that is the substrate part to be plated, is attached to a fixture, such as a rack, capable of carrying electric current. Typical plating racks manufactured from copper and stainless steel and normally coated with a plastisol protective coating are suitable. The parts to be plated, which are attached to the plating rack, are processed through a preplate process to prepare the non-conductive substrate for electroless deposition.

Typical preplating processes commonly known to those skilled in the electroless plating art can be employed. For example, in processing plastic such as ABS for decorative plating applications the usual chromic acid based etchant is used to etch the plastic, followed by the usual neutralization, preactivation or conditioning steps, catalyzation, such as by using palladium-tin solutions, and acceleration, with the typical water rinsing steps following each. For processing printed circuit boards, the typical solutions associated with preparing those substrates for electroless plating are used.

After the substrate material bearing the catalyzed non-conductive surface has been processed suitably to accept electroless deposition, it is ready for immersion in the electroless plating bath. Upon immersion in the elctroless plating bath, a chemical reduction reaction occurs producing adherent conductive copper film over the non-conductive substrate. As the deposited metal builds, the noncatalytic nature of this deposited metal prevents further chemical deposition at which point the self-limiting thickness is realized.

According to the method of this invention, a negative potential electric current is applied through the conductive plating rack to which the parts to be plated are attached. The current is carried to the metal film on the substrate part resulting in electric deposition of metal on the substrate and allowing for buildup of a deposit of desired thickness. The electric current may be applied to the plating rack immediately upon immersion in the electroless bath or at any time thereafter. However, the non-conductive substrate will not carry the current until sufficient metal is deposited by chemical reduction to enable the electric effect to be realized.

In order to apply the electric current an electric circuit must be completed by immersing electrodes, in this case anodes, in or in contact with the electroless plating bath. Many types of anode materials may be used successfully including insoluble anodes such as those made of carbon graphite, stainless steel, or platinized titanium. Soluble anodes, such as copper, may also be used. A soluble anode of copper may be advantageously used in copper baths because the oxidation effect can be a source of cupric ions to maintain the dissolved copper concentration in the electroless bath at the desired level. An advantageous anode area is selected such that it results in a one-to-one ratio with the cathode, that is, plating deposit, area.

The preferred amount of current applied ranges from $3,22 \cdot 10^{-5}$ to $1,08 \cdot 10^{-2}$ amps per sq. cm of processing, that is, plating, area. Current densities lower than $3,22 \cdot 10^{-5}$ amps per sq. cm. may be inadequate to deposit metal in a reasonable time. Current densities greater than $1,08 \cdot 10^{-2}$ amps per sq. cm. may result in poor deposits of metal, especially on corners or sharp edges of the plated parts.

The following examples illustrate preferred conditions for practicing the invention.

Example 1

In this example, a series of $7,6 \cdot 8,9$ cm test plaques method of standard commercial plating grade ABS were first processed in a chemical using a chromic-sulfuric acid mixture following the operating conditions, concentration, and time of treatment disclosed in U.S. Patent No. 3,515,649. Following thorough rinsing and neutralization of residual chromic acid, the plaques are catalyzed in the known "one-step" method using a mixed palladium-tin catalyst of commercial type disclosed in U.S. Patent No. 3,352,518.

4

After rinsing, the catalyzed plaques are placed in an accelerating solution to activate the catalyzed surface making it more receptive to electroless deposition. Many types of accelerating baths may be employed, for example the one disclosed in U.S. Patent No. 3,352,518. Such accelerating baths generally comprise an acid solution although alkali accelerators, such as sodium hydroxide solution, have also been used successfully. The plaques are then ready, after further rinsing, for copper plating.

The copper bath used in this example has the following composition:

| | |
|---|---|
| $CuCl_2$ $2H_2O$ | 0.12 M (20 g/l) |
| "Hampol®" (HEEDTA) | 0.148 M (56 g/l) |
| $NaH_2PO_2H_2O$ | 0.34 M (36 g/l) |
| Water | to make one liter |

The pH is adjusted, using hydrochloric acid or sodium hydroxide, to a pH of approximately 9.0. The bath is maintained at a temperature of 140 to 150°F. (60 to 66°C).

The ABS plaques are placed in a plating rack and immersed in the electroless plating bath. Shortly after the plaques are immersed in the bath, an adherent copper film forms on the catalyzed ABS surface. Electric current is applied to the plating rack holding the plaque and begins to register current flow as the electroless copper film builds. The circuit is completed using a carbon anode which is also immersed in the plating bath and connected to the positive terminal of a plating rectifier which supplies the current. Runs were made using various immersion times and various current densities and the deposit thickness measured. The results are set forth in Table 1.

Table 1 shows results of the thickness of copper deposit obtained with and without electric current as well as at various times and current densities. The results illustrate the self-limiting nature of the electroless bath when no current is applied. The particular formulation of this bath allows for a plate thickness of about 0,3 to 0,33 µm which discontinues regardless of the length of immersion. The results show that use of current give a linear increase in deposit thickness at a given current density for increasing immersion time. It also illustrates that for a given immersion time, deposit thickness increases with increasing current density.

### TABLE 1

| Immersion time | 5 min. | 10 min. | 15 min. | 30 min. | 60 min. | 120 min. |
|---|---|---|---|---|---|---|
| Current density Amps/cm$^2$ | | | Deposit thickness in mm | | | |
| $3.36 \times 10^{-5}$ | 0.248 | 0.322 | 0.342 | 0.348 | 0.411 | 0.417 |
| $6.72 \times 10^{-5}$ | 0.251 | 0.328 | 0.351 | 0.353 | 0.448 | 0.516 |
| $1.35 \times 10^{-4}$ | 0.259 | 0.344 | 0.376 | 0.415 | 0.546 | 0.713 |
| $2.69 \times 10^{-4}$ | 0.272 | 0.371 | 0.416 | 0.496 | 0.708 | 1.037 |
| $5.38 \times 10^{-4}$ | 0.300 | 0.426 | 0.504 | 0.662 | 1.040 | 1.701 |
| $1.08 \times 10^{-3}$ | 0.350 | 0.526 | 0.648 | 0.960 | 1.636 | 2.893 |
| $2.15 \times 10^{-3}$ | 0.489 | 0.804 | 1.065 | 1.794 | 3.304 | 6.228 |
| $4.31 \times 10^{-3}$ | 0.705 | 1.236 | 1.713 | 3.089 | 5.894 | 11.409 |
| $8.61 \times 10^{-3}$ | 1.233 | 2.292 | 3.297 | 6.258 | 12.231 | 24.083 |
| $1.08 \times 10^{-2}$ | 2.223 | 4.272 | 6.266 | 12.197 | 24.109 | 46.839 |
| No current | 0.248 | 0.313 | 0.328 | 0.320 | 0.356 | 0.330 |

Example 2

A second series of test plaques molded of a standard commercial grade of ABS were processed identically as in Example 1. In this example, an electroless copper bath identical in all respcts to that of Example 1 was used, except that the complexor, Hampol (HEEDTA) in the electroless bath was changed to "Hampene Na4" (tetrasodium EDTA) at the same concentration of 0.148 Moles. The results obtained were nearly identical to those of Example 1 and show approximately the same deposit thicknesses. The only significant difference was that the self-limiting deposit thickness in this example with no current application was about 0,23—0,25 μm for the EDTA as opposed to the 0,30 to 0,33 μm obtained with the HEEDTA in Example 1.

Example 3

A variety of typical automotive components molded from both a commercial plating grade ABS and from commercial plating grade polyphenylene oxide (Noryl) were processed through preplate cycles as described in Example 1. A preactivator step was utilized for processing the Noryl components. The parts were processed through an electroless copper bath as described in Example 1. Current was applied at a variety of current densities and immersion times giving deposit thicknesses varying from 0,38 to 2,54 μm. These parts were then processed through standard electroplating baths of bright acid copper, bright nickel, and chrome plate to give a finished decorative chrome plated part. Adhesion tests of the metal to the plastic substrate gave adherence values of about 1.4 to 1.8 Kg/cm., a value typically obtained with commercial autocatalytic electroless plating techniques. Thermal cycling and corrosion (CASS) testing performed on the parts demonstrates that presently established automotive specifications are met.

Example 4

ABS plastic parts molded in the shape of a cone having an internal recess approximately 2.5 centimeters deep were processed through a preplate process as described in Example 1 to catalyze the surface making it ready for electroless deposition. Two parts were immersed in a "Bath A", having the composition given below, for 10 minutes without using any current to give approximately 0.3 μm of a uniform electrolessly deposited copper over the parts.

|  | Bath A | Bath B |
| --- | --- | --- |
| $CuCl_2 2H_2O$ | 0.12 Moles | 0.12 Moles |
| "Hampol"® (HEEDTA) | 0.148 Moles | 0.148 Moles |
| $NaH_2PO_2H_2O$ | 0.34 Moles | 0.00 Moles |
| Water | to make one liter | |
| pH adjusted (HCl or NaOH) | pH 9.0 | pH 9.0 |
| Temperature | 62.8°C | 62.8°C |

One part was removed from bath A, its deposit weight measured, and immersed in a "Bath B" having the compisition given above. Each bath had its pH adjusted to approximately 9.0, was at a temperature of 62.8°C. and contained a carbon anode connected to a supply of electric current.

The electrolessly plated parts were then made cathodic in their respective baths, Bath A and Bath B, using an average current density of about $8,6 \cdot 10^{-3}$ amps per $cm^2$ while tied to a circuit with a copper coulometer. After a period of 90 minutes of plating time, both parts were removed and the weight of deposited copper on each was measured. The weights of copper deposited on each part due to the electrolytic action were approximately the same and were between 98 and 100% efficient.

Two other sets of identical ABS cones were processed as described above. Each cone was cross sectioned and the copper thickness deposited in the deepest internal recess of the cone was measured microscopically. The results are set forth in Table 2.

TABLE 2

| Bath A | Bath B | |
| --- | --- | --- |
| 18,67 μm | 15,52 μm | Inside of cone facing toward carbon anode |
| 15,62 μm | 10,85 μm | Inside of cone facing away from carbon anode |

Since the weight of copper deposited on each cone was about the same using either Bath A or Bath B with electric current, and since Bath A shows a greater deposit thickness in the deep recess of the cone, a low current density area, the results demonstrate that the electroless bath (Bath A containing the hypophosphite reducing agent) affords more uniform distribution of plate.

A further study of this surprising result of mere uniform distribution of plates was made using flat panels at the controlled current densities from $3.36 \times 10^{-5}$ to $8.61 \times 10^{-3}$ Amp.Cm$^{-2}$ set out in Table 1. The flat panels were processed identically to the cones described above, and plated for an equivalent amount of

6

ampere-minutes at each current density. The amount of copper deposited on both Baths A and B remained approximately equivalent from $8.61 \times 10^{-3}$ cm$^{-2}$ down to about $2.69 \times 10^{-4}$ cm$^{-2}$ at which time the amount of copper deposited from Bath B (without reducing agent) fell giving only 50 percent of the amount deposited by Bath A at a current density of $3.36 \times 10^{-5}$ amp cm$^{-2}$. This further demonstrates that the electroless bath (Bath A containing sodium hypophosphite) gives better efficiency at lower current densities than the non-electroless bath (Bath B containing no sodium hypophosphite). This would advantageously result in more uniform deposits on complexly shaped parts.

Example 5

Another series of test plaques were processed identically as described in Example 1 except a copper anode was used in place of the carbon anode of Example 1. Similar results were obtained.

Example 6

Another series of test plaques were processed identically as described in Example 1 except a 316 stainless steel anode was used in place of the carbon anode of Example 1. Similar results were obtained.

Example 7

Standard 1 oz (0,28 g), two sided, copper-clad, FR-4, epoxy glass laminate board was drilled to obtain holes ranging from 0,254 to 1,27 mm in diameter. The laminate was then processed in a commercial plated through hole (PTH) cycle to prepare the hole walls and laminate surface for electroless deposition. The PTH cycle uses a series of cleaning and etching steps, followed by catalyzation with tin-palladium, and accelerator steps similar to those used for plating ABS plastic.

The catalyzed board was then immersed in an electroless copper bath as described in Example 1. The board was made cathodic with a current density of about $6.5 \cdot 10^{-3}$ amp·cm$^{-2}$ and left in solution for 15 minutes, at which time the board was removed from the electroless bath, rinsed, and dried. Inspection of the hole walls revealed a uniform coating of copper about 2.54 µm in thickness. The copper deposit completely covered the epoxy and glass fibers of the hole walls with no voiding of deposit evident.

The laminate board was further processed to produce a finished circuit board. After the PTH process the dried board was imaged with a plating resist leaving exposed the desired circuit traces and holes. Imaging of the plating resist can be accomplished with silk screening, or photo chemical technique as is known. The board was then processed through solutions which cleaned and pickled the exposed circuit traces and holes in preparation for further electroplating. The circuit traces and holes were plated with an acid copper plating solution to a thickness of about 1 thousandth of an inch, followed by solder plate to a thickness of about 0.51 µm. Next the plating resist was chemically removed and the copper cladding chemically stripped away yielding a finished circuit board with copper and solder plated circuit traces and holes.

The finished board was then tested for "solder shock" by an immersion in 260°C molten solder for 10 seconds. The holes were then cross-sectioned and examined under a microscope revealing a well plugged solder hole, the copper deposit remaining completely intact throughout the hole wall.

**Claims**

1. A method of depositing a copper plating on the surface of a workpiece which comprises the steps of preparing the workpiece surface to render it more receptive to plating, immersing the workpiece in an electroless plating solution comprising, in addition to water, a soluble source of copper ions, a complexing agent to maintain the copper ions in solution and a soluble reducing agent effective to reduce the copper ions to metallic copper as a deposit on the surface of the workpiece when in contact with the plating solution, applying a negative potential to the partially plated workpiece and completing an electric circuit by placing an anode in effective electrical contact with the solution to continue the plating by electrolysis in the plating solution characterised in that the reducing agent is a hypophosphite.

2. A method according to claim 1, wherein the electric current applied to the workpiece has a current density ranging from $3.22 \times 10^{-5}$ to $1.08 \times 10^{-2}$ amps per square centimetre of processing area.

3. A method according to claim 1 or claim 2, wherein the workpiece has a catalysed non-conductive surface prior to immersion in the solution.

4. A method according to any preceding claim wherein the electric current is not applied until the workpiece has a metallic copper plating electrolessly deposited on it.

5. A method according to claim 4, wherein the electric current is applied when the electrolessly deposited metallic copper plating has reached the self limiting thickness of the plating solution.

6. A method according to any preceding claim wherein the workpiece has a complex shape.

**Patentansprüche**

1. Verfahren zum Niederschlagen eines Kupferüberzuges auf der Oberfläche eines Werkstückes, enthaltend die Schritte des Vorbereitens des Werkstückes, um es für den Galvanisierungsvorgang empfindlicher zu machen, des Eintauchens des Werkstückes in eine elektrofreie Galvanisierungslösung, die zusätzlich zum Wasser eine lösliche Kupferionenquelle, einen Komplexbildner zum Aufrechterhalten der Kupferionen in Lösung und ein lösliches Reduzierungsmittel enthält, das die Reduzierung der Kupferionen zu metallischem Kupfer als Niederschlag auf der Oberfläche des Werkstückes bewirkt, wenn es mit der Galvanisierungslösung in Kontakt ist, des Anwendens eines negativen Potentials an dem teilweise galvanisierten Werkstück und des Vervollständigens eines elektrischen Kreises durch wirksames elektrisches Inkontaktbringen einer Anode mit der Galvanisierungslösung, um das Galvanisieren durch Elektrolyse in der Galvanisierungslösung fortzusetzen, dadurch gekennzeichnet, daß das Reduzierungsmittel ein Hypophosphit ist.

2. Verfahren nach Anspruch 1, dadurch gekennzeichnet, daß der an dem Werkstück angeschlossene Strom eine Dichte aufweist, die in dem Bereich von $3{,}22 \times 10^{-5}$ bis $1{,}08 \times 10^{-2}$ Amperesekunden pro cm² Behandlungsfläche liegt.

3. Verfahren nach Anspruch 1 oder 2, dadurch gekennzeichnet, daß das Werkstück vor dem Eintauchen in die Lösung eine katalysierte, nichtleitende Oberfläche aufweist.

4. Verfahren nach jedem vorhergehenden Anspruch, dadurch gekennzeichnet, daß der elektrische Strom nicht angewendet wird, bis das Werkstück einen auf ihm elektrtrofrei niedergeschlagenen, metallischen Kupferüberzug aufweist.

5. Verfahren nach Anspruch 4, dadurch gekennzeichnet, daß der elektrische Strom angewendet wird, wenn der elektrofrei niedergeschlagene, metallische Kupferüberzug die selbstbegrenzende Dicke der Galvanisierungslösung erreicht hat.

6. Verfahren nach jedem vorhergehenden Anspruch, dadurch gekennzeichnet, daß das Werkstück eine komplizierte Form aufweist.

## Revendications

1. Procédé pour déposer un dépôt de cuivre sur la surface d'une pièce en oeuvre, qui comprend les étapes consistant à préparer la surface de la pièce pour la rendre plus apte au cuivrage, à immerger la pièce dans une solution de cuivrage catalytique comprenant outre de l'eau une source soluble d'ions cuivre un agent complexant pour maintenir les ions cuivre en solution et un agent réducteur soluble, à même de réduire les ions cuivre en cuivre métallique sous la forme d'un dépôt sur la surface de la pièce quand elle est en contact avec la solution de cuivrage, à appliquer un potentiel négatif à la pièce partiellement cuivrée et à réaliser un circuit électrique en plaçant une anode en contact électrique efficace avec la solution, pour poursuivre le dépôt par électrolyse dans la solution de cuivrage, caractérisé en ce que l'agent réducteur est un hypophosphite.

2. Procédé selon la revendication 1, dans lequel le courant appliqué à la pièce a une densité de courant de $3.22 \times 10^{-5}$ à $1.08 \times 10^{-2}$ ampères per centimètres carrés d'aire de traitement.

3. Procédé selon la revendication 1 ou la revendication 2, dans lequel la pièce a, avant immersion dans la solution, une surface catalysée non-conductrice.

4. Procédé selon l'une quelconque des revendications précédentes, dans lequel le courant électrique n'est pas appliqué avant qu'un cuivrage métallique n'ait été déposé sur la pièce par dépôt auto-catalytique.

5. Procédé selon la revendication 4, dans lequel le courant électrique est appliqué quand le cuivrage métallique déposé par dépôt autocatalytique a atteint l'épaisseur limite spontanée de la solution de cuivrage.

6. Procédé selon l'une quelconque des revendications précédentes dans lequel la pièce à une forme complexe.